## Europäisches Patentamt

## European Patent Office

## Office européen des brevets

(11) Publication number: **0 073 721**
**B1**

(12) **EUROPEAN PATENT SPECIFICATION**

(45) Date of publication of patent specification: **28.10.87**

(51) Int. Cl.⁴: **H 01 L 21/66, H 01 L 27/02**

(21) Application number: **82401588.7**

(22) Date of filing: **26.08.82**

(54) **Large scala integration semiconductor device having monitor element and method of manufacturing the same.**

(30) Priority: **28.08.81 JP 135211/81**

(43) Date of publication of application:
**09.03.83 Bulletin 83/10**

(45) Publication of the grant of the patent:
**28.10.87 Bulletin 87/44**

(84) Designated Contracting States:
**DE FR GB**

(56) References cited:
**US-A-4 243 937**

**IBM TECHNICAL DISCLOSURE BULLETIN, vol. 17, no. 9, February 1975, pp. 2577-2578, New York (US); A.K.GHATALIA et al.: "Semiconductor process defect monitor"**

**IBM TECHNICAL DISCLOSURE BULLETIN, vol. 22, no. 6, November 1979, pp. 2448-2449, New York (US); J.B.VOGE: "Detection of shorting defects by resistance measurement"**

**IBM TECHNICAL DISCLOSURE BULLETIN, vol. 19, no. 3, August 1976, pp. 898-899, New York (US); N.E.HALLAS et al.: "Test structure for semiconductor chips"**

(73) Proprietor: **FUJITSU LIMITED**
**1015, Kamikodanaka Nakahara-ku**
**Kawasaki-shi Kanagawa 211 (JP)**

(72) Inventor: **Tanizawa, Tetsu**
**Dai-2-Yurigaoka-ryo 2-7-5, Chiyogaoka Asao-ku**
**Kawasaki-shi Kanagawa 215 (JP)**
Inventor: **Omichi, Hitoshi**
**Dai-2-Taihei-so, 203 Shukugawara Tama-ku**
**Kawasaki-shi Kanagawa 214 (JP)**
Inventor: **Mitono, Yoshiharu**
**1-14-12, Sakuragaoka Setagaya-ku**
**Tokyo 156 (JP)**

(74) Representative: **Descourtieux, Philippe et al**
**CABINET BEAU de LOMENIE 55 rue d'Amsterdam**
**F-75008 Paris (FR)**

## Description

### Technical Field

The present invention relates to a large-scale integration semiconductor device wherein a monitor element for monitoring the wiring formation condition is formed on the product chip of the semiconductor device.

### Background Art

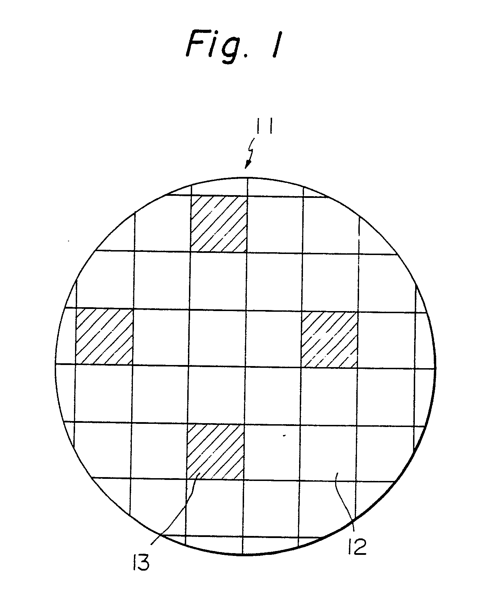

Conventionally, in order to monitor the occurrence of defective products in the manufacturing process of large scale integration (LSI) circuits, monitor chips are formed on appropriate positions of a wafer at the same time as the LSI product chips, as shown in Fig. 1. Figure 1 shows a semiconductor wafer 11 from which a large number of LSI chips 12 including monitor chips 13 are produced in matrix fashion. One of the monitor chips 13 has a circuit for monitoring the formation of active elements such as diodes and transistors. The monitor chip 13 is used for inspecting for faults arising from the manufacturing process of the LSI chips.

Recently, however, LSI chips have been designed both for greater integration scale and increased dimensions. This has meant fewer product chips obtained from one piece of wafer. Under such conditions, it is not desirable to form monitor chips on wafers, each monitor chip would mean one less product chip.

Further, forming monitor chips on the wafer increases the time necessary for manufacturing LSI chips, especially when using the direct-step-and-repeat-method exposing process.

Still further, such LSI chips of increased integration scale have a greater area of metal wirings connecting the bulks than the area of active bulks in the chip. Recent developments in LSI manufacturing technology have also significantly reduced the possibility of faults in the active bulk area. Thus, the main factor behind faults in the product chips has become the formation of the multi-layer metal wirings. Faults in the active bulk area can now be neglected. Use of monitor chips to check only the wiring formation in product chips would be inefficient.

In an article by A. K. Ghatalia et al, in IBM Technical Disclosure Bulletin, 1975, pages 2577—2578, it is suggested to detect defects in the wiring formation of a semiconductor device by providing monitoring patterns passing over various topological regions in the kerf area between semiconductor chips on product wafers.

### Summary of the Invention

It is an object of the invention to enable the detection of defects in the wiring formation in large scale integration semiconductor devices by using monitor conduction patterns, thereby eliminating the need for monitor chips.

According to the invention as claimed in claim 1, the semiconductor substrate has a depression provided with a surface having a first step and a coating film formed on the substrate surface and having a second step, whereby a pattern in the form of a closed loop is formed of the first step and the second step; a conduction pattern is formed on the substrate surface and on the coating film, the conduction pattern following the line of, and crossing and recrossing the closed loop formed by the pattern; and the monitor element is formed in an unused area of the chip. According to the inventions as claimed in claim 5, a method of manufacturing a large scale integration semiconductor chip is also proposed.

The invention will be more readily understood from the following description made with reference to the accompanying drawings.

### Brief Description of the Drawings

Figure 1 illustrates a wafer on which LSI chips and monitor chips are formed according to a prior art;

Fig. 2 illustrates a semiconductor device in accordance with one embodiment of the present invention;

Fig. 3 illustrates the monitor element of the semiconductor device of Fig. 4;

Figs. 4A, 4B, and 4C illustrate a principal portion of the monitor element of Fig. 3; and

Figs. 5A and 5B illustrate a principal portion of a monitor element of a semiconductor device in accordance with another embodiment of the present invention.

### Description of the Preferred Embodiments

An LSI semiconductor device having a monitor element in accordance with one embodiment of the present invention is now described with reference to the accompanying drawings.

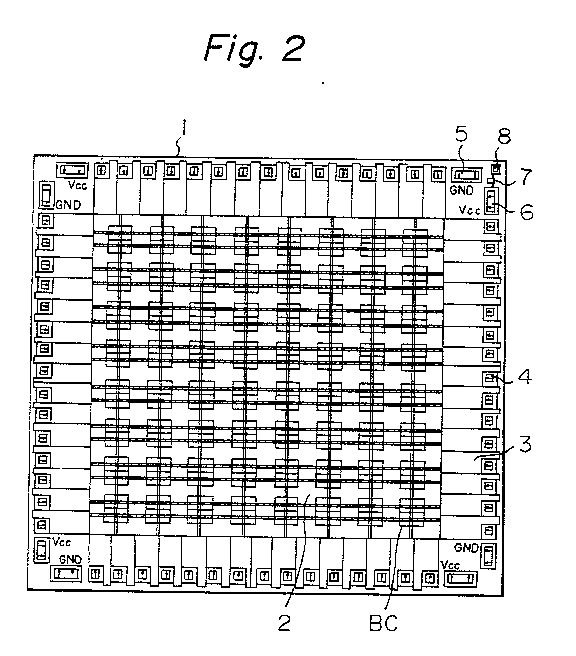

Figure 2 shows a plan view of the LSI semiconductor device. The LSI semiconductor device may be manufactured by using a master-slice method. In the LSI of Fig. 2, a plurality of basic cells BC are arranged in matrix fashion in a basic cell array 2. The basic cell array 2 is formed on the center of an LSI chip 1. Input/output buffers 3 are formed along the sides of the LSI chip 1. Signal pads 4 for input/output buffers 3 are arranged in rows along the sides of the LSI chip 1. In the corners of the LSI chip 1, pads 5 and 6 for the ground GND and for the voltage source $V_{cc}$ are formed. The areas around the pads 5 and 6 are not used in the semiconductor device. A monitor element 7 and a monitor pad 8 are formed in one corner of the LSI chip 1.

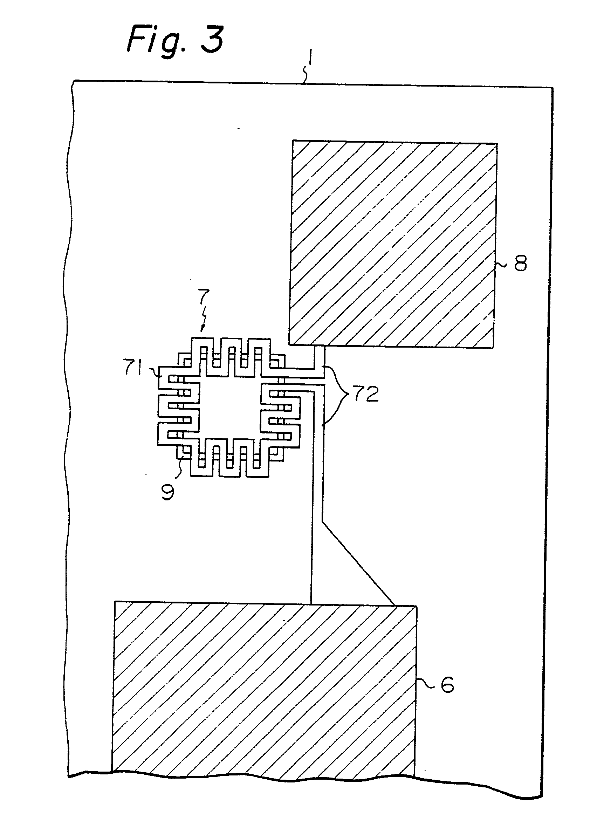

The monitor element 7 of Fig. 2 is illustrated in more detail in Fig. 3. Figure 3 shows an enlarged view of a corner of the LSI 1. The monitor element 7 is formed above a depression 1 formed in the unused area of the LSI chip 1. The monitor element 7 has a wiring pattern 71 and monitor terminal portions 72. The wiring pattern 71 has a wiring portion, and the wiring portion is formed in the same process step of forming a wiring layer for interconnecting the active elements such as diodes and transistors. The wiring pattern 71 of the monitor element 7 is formed along the step portion (9) of the depression in such a way that the wiring line of the wiring pattern 71 runs back and forth across the step portion (9) of the depression. The ends of the wiring pattern 71 are connected to the pad for the voltage source 6 and the monitor pad 8 through the monitor terminal portions 72.

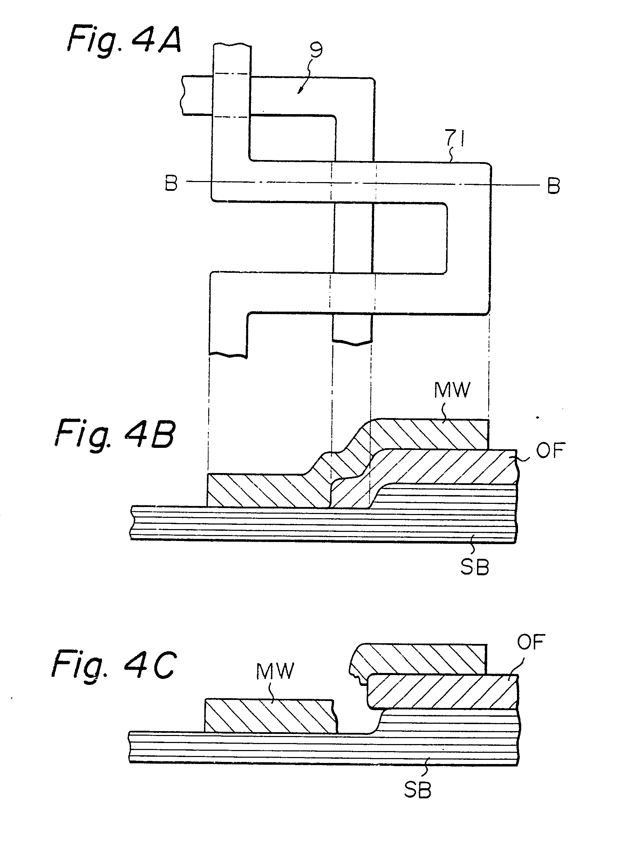

A principal portion of the wiring pattern 71 of the monitor element 7 is illustrated in Figs. 4A and 4B. Figure 4B is a sectional view of the above-mentioned portion along the line B—B. In Fig. 4B, SB indicates a semiconductor substrate, OF indicates an oxidation film of polysilicon or phosphosilicate glass (PSG), and MW indicates a metal wiring layer. The structure of the metal wiring layer MW of Fig. 4B is used for monitoring the wiring formation of the LSI chip, i.e., to determine whether any faults have occurred in the wiring lines in the manufacturing process.

Short-circuits or disconnection of the wiring line may occur at the step portion of the wiring pattern 71. Figure 4C shows the sectional view of the wiring pattern 71 in which the disconnection of the metal wiring layer MW is produced by poor positioning or etching in the manufacturing process. The above-mentioned fault of the wiring layer can be detected by using the pad for voltage source 6 and the monitor pad 8 (Fig. 3).

The line width of the wiring pattern 71 of the monitor element may be designed to be equal to the minimum line width of the wiring lines used for forming the semiconductor device in order to monitor the worst condition for the wiring formation.

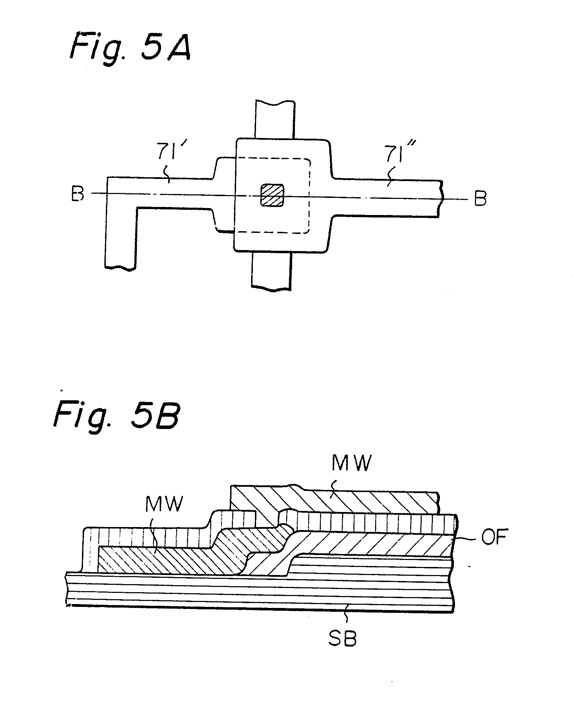

The wiring pattern 71 of the monitor element 7 according to the present invention may have a through hole portion as shown in Figs. 5A and 5B. In Fig. 5A, two wiring patterns 71′ and 71″ are connected to each other via a through hole.

As described above, according to the present invention, the wiring formation in an LSI chip can be monitored without using monitor chips. Therefore, the effective number of product chips produced from one wafer can be increased. Further, since it is not necessary to form two types of chips (product chips and monitor chips) on the same wafer, the efficiency of manufacture of the LSI chips can be increased, even when the direct-step-and-repeat-method exposing process is used. Still further, since the monitor elements are formed in the unused area (dead area) of the LSI chips, the overall area of the LSI chips can be used more efficiently.

## Claims

1. A large scale integration semiconductor chip with a plurality of active elements formed in a semiconductor substrate, a wiring layer interconnecting the active elements, and a monitor element (7) having a conduction pattern (71) and pads (6, 8) connected to both ends of the conduction pattern for monitoring defects in the wiring layer in said chip, characterized in that:
— the semiconductor substrate (SB) has a surface having a depression provided with a first step and a coating film (OF) formed on said surface and having a second step, a pattern (9) in the form of a closed loop being formed of said first step and said second step,
— the conduction pattern (71; 71′—71″) is formed on said surface of the semiconductor substrate and on said coating film, said conduction pattern following the line of, and crossing and recrossing, said closed loop of said pattern (9), and
— the monitor element (7) being formed in an unused area of the chip.

2. A large scale integration semiconductor device according to claim 1, characterized in that the conduction pattern (71′—71″) has a through hole connecting portion.

3. A large scale integration semiconductor device according to any one of claims 1 and 2, characterized in that said conduction pattern (71; 71′—71″) has a line width which is equal to the minimum line width of lines of said wiring layer interconnecting said active elements.

4. A large scale integration semiconductor device according to any one of claims 1 to 3, characterized in that said semiconductor device is fabricated by a master-slice method.

5. A method of manufacturing a large scale integration semiconductor chip, including the steps of forming a plurality of active elements in a semiconductor substrate and a wiring layer for interconnecting said active elements, and of forming a monitor element having a conduction pattern for monitoring defects in the wiring formation in said chip, characterized in that a depression is formed in a surface of the substrate in an unused area of the chip and is joined to the adjacent substrate surface by a step portion, and said conduction pattern is formed on said substrate surface in said unused area of the chip so as to meander across said step portion and across and over the boundary between said step portion and, respectively, the depression and the adjacent substrate surface.

## Patentansprüche

1. Large-Scale-Integration-Halbleiterchip mit einer Vielzahl von aktiven Elementen, die in einem Halbleitersubstrat gebildet sind, einer Verdrahtungsschicht, die die aktiven Elemente miteinander verbindet, und einem Monitorelement (7), das ein Leitungsmuster (71) und Pads (6, 8) hat, die mit beiden Enden der Leitungsmuster verbunden sind, um Defekte in der Verdrahtungsschicht des genannten Chips zu überwachen, dadurch gekennzeichnet, daß:
— das Halbleitersubstrat (SB) eine Oberfläche hat, die eine Depression hat, welche eine erste Stufe aufweist, und einen Überzugfilm (OF), der auf der genannten Oberfläche gebildet ist und eine zweite Stufe hat, und ein Leitungsmuster (9) in Form einer geschlossenen Schleife auf der genannten ersten Stufe und der genannten zweiten Stufe gebildet ist,
— das Leitungsmuster (71; 71′—71″) auf der genannten Oberfläche des Halbleitersubstrats und auf dem genannten Überzugfilm gebildet ist, das genannte Leitungsmuster der Leitung der genannten geschlossenen Schleife des genannten Musters folgt, es kreuzt und wieder zurück kreuzt, und

— das Monitorelement (7) in einem unbenutzten Bereich des Chips gebildet ist.

2. Large-Scale-Integration-Halbleitervorrichtung nach Anspruch 1, dadurch gekennzeichnet, daß das Leitungsmuster (71'—71") einen Durchgangsloch-Verbindungsabschnitt hat.

3. Large-Scale-Integration-Halbleitervorrichtung nach einem der Ansprüche 1 oder 2, dadurch gekennzeichnet, daß das genannte Leitungsmuster (71; 71'—71") eine Leitungsbreite hat, die gleich der minimalen Leitungsbreite der genannten Leitungen der genannten Verdrahtungsschicht ist, welche die aktiven Elemente miteinander verbindet.

4. Large-Scale-Integration-Halbleitervorrichtung nach einem der Ansprüche 1 bis 3, dadurch gekennzeichnet, daß die genannte Halbleitervorrichtung durch ein Mutterscheibenverfahren hergestellt wird.

5. Verfahren zur Herstellung eines Large-Scale-Integration-Halbleiterchips, mit den Schritten der Bildung einer Vielzahl von aktiven Elementen in einem Halbleitersubstrat und einer Verdrahtungsschicht zum Verbinden der genannten aktiven Elemente miteinander, und der Bildung eines Monitorelements, welches ein Leitungsmuster zum Überwachen von Defekten in der Verdrahtungsformation des genannten Chips hat, dadurch gekennzeichnet, daß eine Depression in einer Oberfläche des Substrats in einem unbenutzten Bereich des Chip gebildet und mit der benachbarten Substratoberfläche durch einen Stufenabschnitt verbunden wird, und das genannte Leitungsmuster auf der genannten Substratoberfläche in dem genannten unbenutzten Bereich des Chips so gebildet wird, daß es quer über den genannten Stufenabschnitt und quer über die Grenze zwischen dem genannten Stufenabschitt bzw. der Depression und der benachbarten Substratoberfläche meandriert.

**Revendications**

1. Puce semiconductrice intégrée à grande échelle possédant plusieurs éléments actifs formés dans un substrat semiconducteur, une couche de câblage reliant entre eux les éléments actifs, et un élément de contrôle (7) possédant une configuration conductrice (71) et des plots (6, 8) connectés aux deux extrémités de la configuration conductrice afin de contrôler l'existence de défauts dans la couche conductrice de ladite puce, caractérisée en ce que:

— le substrat semiconducteur (SB) possède une surface comportant un creux doté d'un premier cran et une pellicule de revêtement (OF) formée sur ladite surface et comportant un deuxième cran, une configuration (9) ayant la forme d'une boucle fermée étant formée dudit premier cran et dudit deuxième cran,

— la configuration conductrice (71; 71'—71") est formée sur ladite surface du substrat semiconducteur et sur ladite pellicule de revêtement, ladite configuration conductrice suivant la ligne de ladite boucle fermée de ladite configuration (9), et la croisant et la recroisant, et

— l'élément de contrôle (7) étant formé dans une zone non utilisée de la puce.

2. Dispositif à semiconducteur intégré à grande échelle selon la revendication 1, caractérisé en ce que la configuration conductrice (71'—71") possède une partie de connexion utilisant un trou passant.

3. Dispositif à semiconducteur intégré à grande échelle selon l'une quelconque des revendications 1 et 2, caractérisé en ce que ladite configuration conductrice (71; 71'—71") possède une largeur de ligne qui est égale à la largeur de ligne minimale des lignes de ladite couche de câblage reliant entre eux lesdits éléments actifs.

4. Dispositif à semiconducteur intégré à grande échelle selon l'une quelconque des revendications 1 à 3, caractérisé en ce que ledit dispositif à semiconducteur est fabriqué par le procédé de la matrice standard.

5. Procédé de fabrication d'une puce semiconductrice intégrée à grande échelle, comportant les opérations qui consistent à former plusieurs éléments actifs dans un substrat semiconducteur et une couche de câblage servant à interconnecter entre eux lesdits éléments actifs, et à former un élément de contrôle possédant une configuration conductrice afin de contrôler l'existence de défauts dans la formation du câblage de ladite puce, caractérisé en ce qu'on forme un creux dans une surface du substrat en une zone non utilisée de la puce et on la réunit à la surface adjacente du substrat par une partie en cran, et on forme ladite configuration conductrice sur ladite surface du substrat se trouvant dans ladite zone non utilisée de la puce de façon qu'elle sinue en traversant de manière répétée ladite partie en cran tout en franchissant la frontière qui existe entre ladite partie en cran et, respectivement, le creux et la surface adjacente du substrat.

# Fig. 1

# Fig. 2

# Fig. 3

*Fig. 4A*

9

71

B —————————————————————————————————— B

MW

*Fig. 4B*

OF

SB

*Fig. 4C*

OF

MW

SB

*Fig. 5A*

*Fig. 5B*